(19) **Europäisches Patentamt**
**European Patent Office**
**Office européen des brevets**

(11) **EP 1 876 703 B1**

(12) **EUROPEAN PATENT SPECIFICATION**

(45) Date of publication and mention
of the grant of the patent:
**29.12.2010 Bulletin 2010/52**

(51) Int Cl.:
*H04L 27/36* *(2006.01)*  *H03B 27/00* *(2006.01)*

(21) Application number: **07019275.2**

(22) Date of filing: **03.11.2000**

(54) **Modulator with low sensitivity to amplitude and phase errors of the carrier signal**

Modulator mit geringer Anfälligkeit für Amplituden- und Phasenfehler des Trägersignals

Modulateur avec faible densité pour les erreurs de phase et d'amplitude d'un signal de porteur

(84) Designated Contracting States:
**AT BE CH CY DE DK ES FI FR GB GR IE IT LI LU MC NL PT SE TR**

(43) Date of publication of application:
**09.01.2008 Bulletin 2008/02**

(62) Document number(s) of the earlier application(s) in accordance with Art. 76 EPC:
**00976923.3 / 1 330 905**

(73) Proprietor: **QUALCOMM Incorporated**
**San Diego, CA 92121-1714 (US)**

(72) Inventor: **Sahota, Kamal Gurkanwal**
**San Diego**
**CA 92103 (US)**

(74) Representative: **Carstens, Dirk Wilhelm**
**Wagner & Geyer**
**Gewürzmühlstrasse 5**
**80538 München (DE)**

(56) References cited:
**DE-C- 19 934 215**    **US-A- 5 111 155**
**US-A- 5 412 351**    **US-A- 5 438 301**
**US-A- 5 705 958**

**Description**

**BACKGROUND OF THE INVENTION**

**I. Field of the Invention**

The present invention relates to communications systems. More particularly, the present invention relates to a novel and improved quadrature modulator for communications systems.

**II. Description of the Related Art**

In many modem communications systems, digital transmission is utilized because of improved efficiency and enhanced performance. Examples of digital transmission formats include binary phase shift keying (BPSK), quaternary phase shift keying (QPSK), offset quaternary phase shift keying (OQPSK), m-ary phase shift keying (m-PSK), and quadrature amplitude modulation (QAM). Examples of communications systems that utilize digital transmission include code division multiple access (CDMA) communications systems and high definition television (HDTV) systems.

In typical digital communications systems, the signal to be transmitted is digitally generated and initially processed at baseband. The baseband processing can include buffering, filtering, and amplification. The processed baseband signal is then modulated to an intermediate frequency (IF) where additional signal processing (i.e., buffering, filtering, amplification, and so on) can be performed. The modulated and processed IF signal is upconverted to radio frequency (RF), further processed, and transmitted.

At a receiver, the transmitted RF signal is received, processed (i.e., amplified and filtered), and downconverted to an IF frequency (that may or may not match the IF frequency at the transmitter). The IF signal is then demodulated using a demodulation scheme complementary to the modulation scheme used at the transmitter.

In many conventional transmitter and receiver architectures, the modulation and demodulation are performed using analog circuitry. In a common modulator architecture, the baseband I and Q signals are provided to a pair of mixers that also respectively receive an inphase carrier signal (I LO) and a quadrature carrier signal (Q LO). The first mixer modulates the I LO with the I signal to generate the I modulated component, and the second mixer modulates the Q LO with the Q signal to generate the Q modulated component. The I and Q modulated components are then combined by a summer to generate the modulated signal.

This simplified modulator provides acceptable performance when the I LO and Q LO are properly generated (i.e., having amplitude and phase errors within specified limits). These carrier signals are typically generated by analog circuitry, such as a phase shift network or a phase splitter, which invariably exhibits some amounts of error due to various factors such as component tolerance, component mismatch, and so on. The amplitude and/or phase error in these carrier signals produce I and Q modulated components that are not in quadrature (i.e., not 90° out-of-phase between the signals) and not amplitude balanced. The errors in the modulated components can result in performance degradation at the receiver that locks to, and demodulates the received modulated signal. Such degradation can include poor image rejection, residual phase error in the carrier tracking loop, cross-talk between the demodulated I and Q components, and others.

Accordingly, modulators and demodulators that are more insensitive to amplitude and/or phase error in the carrier signals are highly desirable. It is also desirable that the modulators and demodulators be more insensitive to gain and phase errors in the mixers and other circuits that make up these modulators and demodulators.

Attention is drawn to the document US-A- 5,438,301, which discloses a carrier generator circuit for use in a modem employed in a wireless communication system. The carrier generator circuit includes a voltage controlled oscillator comprising an N-stage ring oscillator to generate N balanced vectors of equal magnitude and arbitrary phase difference. The carrier generator circuit also includes a phase corrector to add two of the balanced vectors to generate a sum vector and to subtract the two balanced vectors to generate a difference vector. The sum vector and difference vector have a phase difference of 90 degrees. The sum vector represents an I (inphase) carrier signal component and the difference vector represents a Q (quadrature-phase) carrier signal component. These I and Q carrier signal components can be used to transmit and receive data signals.

Further attention is drawn to the document US-A-5,705,958, which describes an apparatus for correcting quadrature error in a quadrature modulator and/or in a demodulator for a signal having a plurality of phase states, or of amplitude and phase states. The correction apparatus comprises a processor which, when the apparatus is used to correct quadrature error in a demodulator, transforms the levels P and Q of the digital signals output by the demodulation stage into corrected levels P' and Q' that satisfy any one of the eight relationships described ion the patent. These corrected levels are then applied to decision element, optionally after their maximum levels have equalized.

Finally, attention is drawn to the document US-A-5,111,155, which describes that distortion introduced in phase modulated RF signals by amplifiers and other signal processors is substantially reduced by modifying complex modulating signals I, Q in a way that compensates for the amplifier phase error $\varphi_e$ as a function of amplifier power P. The document describes that I, Q are combined to calculate the amplifier power level and scaled by a parameter, e.g., K1=-d$\varphi_e$ /dP, to provide factor B so that compensated signals I"=AQ+BI and Q"=AI-BQ, where A is a constant, can be determined. When an RF carrier modulated by I", Q" is passed through the distorting amplifier the amplifier induced distortion is cancelled. Substantial reduction in bit error probability is obtained.

SUMMARY OF THE INVENTION

In accordance with the present invention a modulator, as set forth in claim 1, is provided. Embodiments of the invention are claimed in the dependent claims.

The present invention provides a modulator architecture having improved performance over conventional architectures. The modulator includes two modulation units. Each unit receives and modulates a set of carrier signals with a set of information signals. The signals to the second unit can be swapped and may be inverted. The use of two modulation units, properly configured, decreases sensitivity to amplitude and/or phase error in the carrier signal and also to gain and/or phase error in the carrier signal, and provides improved image rejection.

An embodiment of the invention provides a modulator that includes four mixers and two summers. The first mixer receives and modulates an inphase carrier signal with an inphase information signal to generate a first modulated component. The second mixer receives and modulates a quadrature carrier signal with a quadrature information signal to generate a second modulated component. The third mixer receives and modulates the inphase carrier signal with the quadrature information signal to generate a third modulated component that includes a signal inversion. The fourth mixer receives and modulates the quadrature carrier signal with the inphase information signal to generate a fourth modulated component. The first summer receives and combines the first and fourth modulated components to generate an inphase modulated component. The second summer receives and combines the second and third modulated components to generate a quadrature modulated component.

A third summer can be used to receive and combine the inphase and quadrature modulated components to provide a modulated signal. The signal inversion can be achieved by inverting either the inphase carrier signal or the quadrature information signal provided to the third mixer. The mixers can be implemented using Gilbert cell multipliers.

Another embodiment of the invention provides a modulator that includes two modulation units. The first modulation unit receives and modulates a set of carrier signals with a set of information signals in accordance with a particular modulation scheme to generate a first modulated component. The second modulation unit receives and modulates the set of carrier signals with the set of information signals in accordance with the particular modulation scheme to generate a second modulated component that includes a signal inversion relative to the first modulation component.

A summer can be used to combine the first and second modulated components to generate a modulated signal. The first and second modulation units can each be configured to provide a mixing function having approximately three signal levels. Each modulation unit can include a pair of mixers and a summer. The first mixer receives and modulates an inphase carrier signal with a first information signal. The second mixer receives and modulates a quadrature carrier signal with a second information signal. The summer receives and combines the outputs from the first and second mixers to provide a modulated component. The information signals provided to the first and second modulation units are swapped and may also be inverted.

**BRIEF DESCRIPTION OF THE DRAWINGS**

The features, nature, and advantages of the present invention will become more apparent from the detailed description set forth below when taken in conjunction with the drawings in which like reference characters identify correspondingly throughout and wherein:

FIG. 1 shows a simplified block diagram of an embodiment of a transmitter that performs quadrature modulation (e.g., QPSK and OQPSK) using two frequency conversion stages;
FIG. 2 shows a simplified block diagram of an embodiment of a transmitter that performs direct quadrature modulation using a single frequency conversion stage;
FIG. 3A shows a block diagram of an embodiment of a conventional quadrature modulator;
FIG. 3B shows a schematic diagram of an embodiment of a conventional quadrature modulator implemented with Gilbert cell mixers;
FIG. 4 shows a block diagram of an embodiment of a quadrature modulator of the invention;
FIG. 5 shows a block diagram of a specific implementation of the quadrature modulator of the invention;
FIG. 6A shows a schematic diagram of a specific embodiment of a Gilbert cell multiplier;
FIG. 6B shows a schematic diagram of a specific embodiment of a transconductance amplifier that receives an input voltage signal and generates an output current signal;

FIG. 7A shows a plot of image rejection versus gain error for a conventional modulator;

FIG. 7B shows a plot of image rejection versus gain error for the modulator shown in FIG. 4;

FIGS. 8 and 9 show block diagrams of two embodiments of a quadrature demodulator; and

FIG. 10 shows plots of the mixing functions $M_I(t)$ and $M_Q(t)$.

## DETAILED DESCRIPTION OF THE SPECIFIC EMBODIMENTS

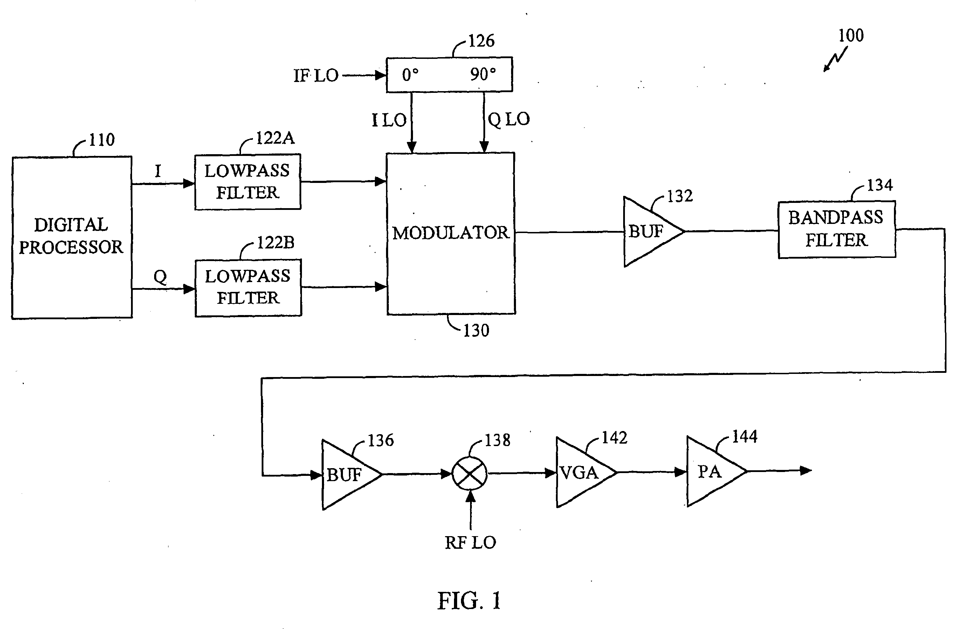

FIG. 1 shows a simplified block diagram of an embodiment of a transmitter 100 that performs quadrature modulation (e.g., QPSK and OQPSK) using two frequency conversion stages. A digital processor 110 generates data, encodes and modulates the data, and converts the digitally processed data into an inphase (I) signal and a quadrature (Q) signal. The baseband I and Q signals are provided to a pair of lowpass filters 122a and 122b, respectively, that perform (i.e., match) filtering of the baseband signals and provide the filtered I and Q signals to a modulator 130. Modulator 130 also receives an inphase carrier signal (I LO) and a quadrature carrier signal (Q LO) from a phase splitter 126 and modulates the carrier signals with the baseband signals to generate a modulated signal at an intermediate frequency (IF). The IF modulated signal from modulator 130 is provided to a buffer 132 that buffers the IF signal and drives a bandpass filter 134. Filter 134 filters the IF signal to remove out-of-band noise and undesired signals and images.

The filtered IF signal is provided to a buffer 136 that buffers the signal and drives a mixer 138. Mixer 138 also receives a carrier signal at a radio frequency (RF LO), and upconverts the buffered signal with the RF LO to generate a RF signal. The RF signal is provided to a variable gain amplifier (VGA) 142 that amplifies the signal with a gain determined by a gain control signal from a gain control circuit (not shown). The amplified RF signal is provided to a power amplifier (PA) 144 that provides the required signal drive. The output of PA 144 couples to an antenna via an isolator and a duplexer (all three elements not shown in FIG.1).

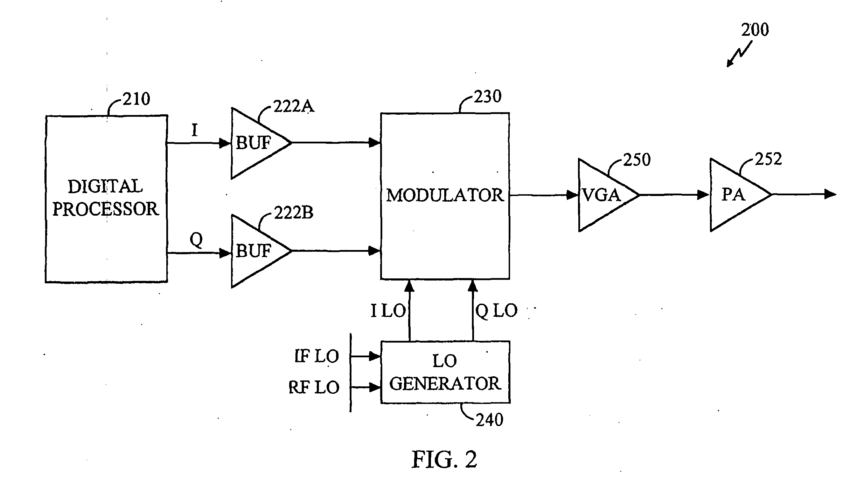

FIG. 2 shows a simplified block diagram of an embodiment of a transmitter 200 that performs direct quadrature modulation using a single frequency conversion stage. A digital processor 210 generates data, encodes and modulates the data, and converts the digitally processed data into an I signal and a Q signal, similar to processor 110 in FIG. 1. The baseband I and Q signals are provided to a pair of buffers 222a and 222b, respectively, that buffer the signals and provide the buffered baseband signals to a modulator 230. Modulator 230 also receives an inphase carrier signal (I LO) and a quadrature carrier signal (Q LO) from a LO generator 240 and modulates the carrier signals with the baseband signals to generate a RF modulated signal. In an embodiment, I LO and Q LO are generated from carrier signals at two frequencies (e.g., an IF LO and a RF LO). The RF modulated signal is provided to a VGA 250 that amplifies signal with a gain determined by a gain control signal (not shown). The amplified RF signal is provided to a PA 252 that drives an antenna.

Various modifications can be made to the transmitter embodiments shown in FIGS. 1 and 2. For example, the transmit signal path can be designed to include fewer or additional buffer and amplifier stages, fewer or additional filter stages, and other circuits. As an example, a filter can be provided after modulator 230 in FIG. 2 to filter out spurious signals. Moreover, the elements within the signal path can be arranged in different configurations. In a specific implementation, the transmit signal path from the digital processor to the PA is implemented within one or more integrated circuits, although discrete elements can also be used.

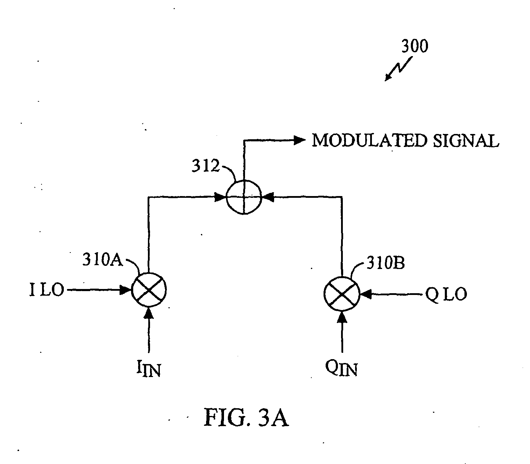

FIG. 3A shows a block diagram of an embodiment of a conventional quadrature modulator 300. Modulator 300 can be used as modulators 130 and 230 in FIGS. 1 and 2, respectively. Within modulator 300, the inphase information signal $I_{IN}$ is provided to a mixer 310a and the quadrature information signal $Q_{IN}$ is provided to a mixer 310b. The inphase and quadrature signals $I_{IN}$ and $Q_{IN}$ are processed versions of the I and Q signals, respectively. Mixers 310a and 310b also receive the carrier signals I LO and Q LO, respectively. Each mixer modulates the carrier signal with the information signal to generate a modulated component. The inphase and quadrature modulated components from mixers 310a and 310b, respectively, are provided to a summer 312 that combines the components to generate the modulated signal.

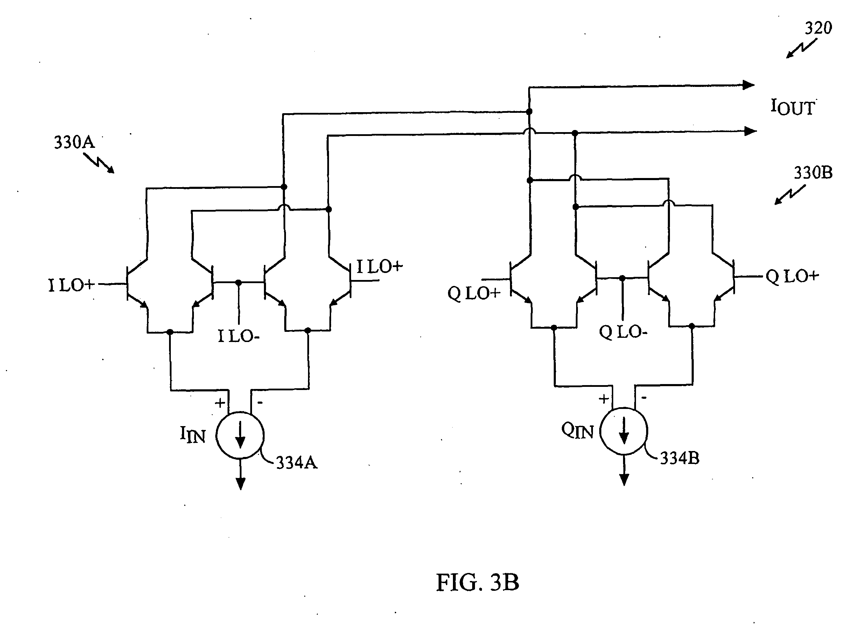

FIG. 3B shows a schematic diagram of an embodiment of a conventional quadrature modulator 320 implemented with Gilbert cell mixers. Modulator 320 is a specific implementation of modulator 300 in FIG. 3A. Mixers 310a and 310b are implemented with Gilbert cell mixers 330a and 330b, respectively, and summer 312 is implemented by cross-coupling the collector outputs of the Gilbert cell mixers. The currents representative of the inphase and quadrature signals $I_{IN}$ and $Q_{IN}$ are provided by respective current sources 334a and 334b that couple to mixers 330a and 330b, respectively. The differential output current $I_{OUT}$ from modulator 320 can be expressed as:

$$I_{OUT} = 2M_{I,G}(t) \bullet \Delta i + 2M_{Q,G}(t) \bullet \Delta q \ , \qquad\qquad \text{Eq. (1)}$$

where

Δi is the differential current related to the inphase information signal $I_{IN}$

$$\{\Delta i = \alpha(I_{IN+} - I_{IN-})/2\};$$

Δq is the differential current related to the quadrature information signal $Q_{IN}$

$$\{\Delta q = \alpha(Q_{IN+} - Q_{IN-})/2\};$$

α is a constant related to the transconductance gain of current sources 334; and $M_{I,G}(t)$ and $M_{Q,G}(t)$ are Gilbert cell mixing functions, which can be expressed as:

$$M_{I,G}(t) = \tanh\left(\frac{I\,LO}{2V_T}\right), \qquad\qquad \text{Eq. (2)}$$

$$M_{Q,G}(t) = \tanh\left(\frac{Q\,LO}{2V_T}\right). \qquad\qquad \text{Eq. (3)}$$

For I LO and Q LO much greater than $2V_T$, $M_{I,G}(t)$ and $M_{Q,G}(t)$ resemble square waves that are shifted by 90 degrees, with $M_{I,G}(t)$ leading $M_{Q,G}(t)$ by 90 degrees.

The simplified modulator architecture in FIG. 3A is susceptible to amplitude and phase errors in the carrier signals, which result in cross-talk between the I and Q modulated components. In modulator 300, any phase error (i.e., from the ideal 90°) in the two carrier signals is directly reflected as the phase error in the modulated components. For example, if the I and Q carrier signals are 90+y degrees out of phase, where y represents the phase error, the I and Q modulated components are also 90+y degrees out of phase and includes a phase error of y. In practical implementations, the carrier signals are limited (e.g., clipped) to reduce amplitude mismatch and variations. Modulator 300 is also susceptible to gain and phase errors in the mixers themselves, which degrade the modulated signal in similar manner as the amplitude and phase errors in the carrier signals. For example, a gain error of x percent (or a phase error of y degrees) in the mixer is equivalent to an amplitude error of x percent (or a phase error of y degrees) in the carrier signal, where x and y may not be linearly related. In modulator 300, the gain or amplitude error in the mixers similarly (and directly) affects the amplitude and phase of the modulated components.

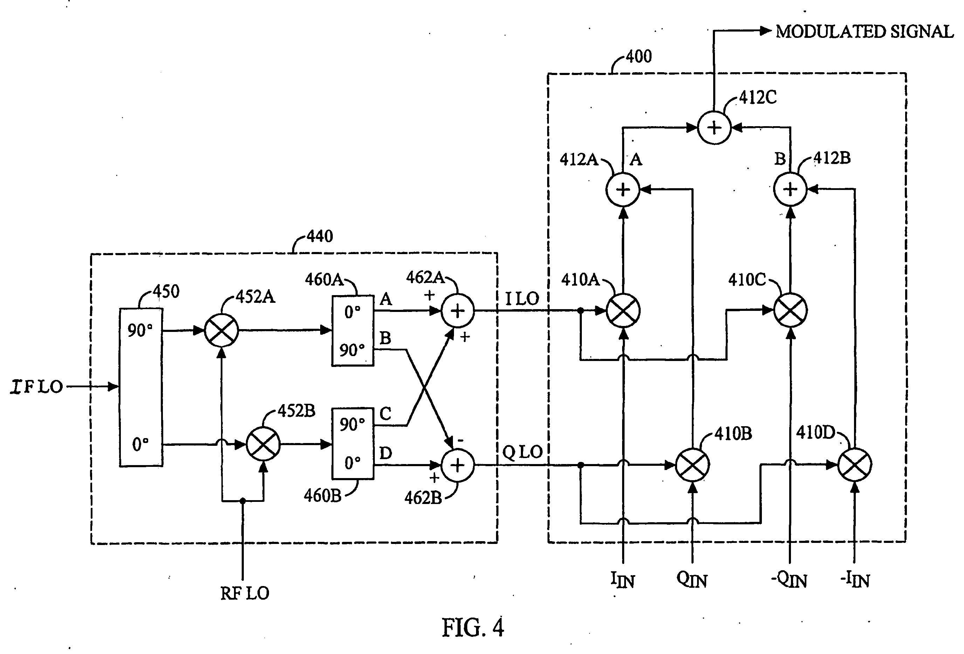

FIG. 4 shows a block diagram of an embodiment of a quadrature modulator 400. Modulator 400 can be used to implement modulators 130 and 230 in FIGS. 1 and 2, respectively. Within modulator 400, the inphase information signal $I_{IN}$ is provided to mixer 410a and the invented signal $-I_{IN}$ to mixer 410d, the quadrature information signal $Q_{IN}$ is provided to a mixer 410b, and the inverted quadrature information signal $-Q_{IN}$ is provided to a mixer 410c. Each of mixers 410a and 410c also receives the inphase carrier signal I LO, and each of mixers 410b and 410d also receives the quadrature carrier signal Q LO. Each mixer modulates the carrier signal with the information signal to generate a modulated component. Specifically, mixer 410a modulates the I LO with the inphase signal $I_{IN}$ to generate a first modulated component, mixer 410b modulates the Q LO with the quadrature signal $Q_{IN}$ to generate a second modulated component, mixer 410c modulates the I LO with the inverted quadrature signal $-Q_{IN}$ to generate a third modulated component, and mixer 410d modulates the Q LO with the inphase signal $I_{IN}$ to generate a fourth modulated component. The first and second modulated components are combined by a summer 412a to generate the modulated output for the first (or left) modulation unit, and the third and fourth modulated components are combined by a summer 412b to generate the modulated output for the second (or right) modulation unit. The outputs from both modulation units are combined by a summer 412c to generate the modulated signal.

Modulator 400 can be viewed as including two modulation units and a summer. One modulation unit comprises mixers 410a and 410b and summer 412a, and the other modulation unit comprises mixers 410c and 410d and summer 412b. Each modulation unit receives a set of information signals (e.g., $I_{IN}$ and $Q_{IN}$) and a set of carrier signals (e.g., I LO and Q LO), and modulates the carrier signals with the information signals in accordance with a particular modulation scheme (e.g., QPSK). The information signals to the mixers within the second modulation unit are swapped and the Q signal or the I LO is also inverted, relative the signals to the mixers within the first modulation unit. Thus, each modulation unit generates a different modulated component.

In the specific modulator embodiment shown in FIG. 4, the second modulation unit receives the information signals $-I_{IN}$ and $-Q_{IN}$ that are used to modulate the Q LO and I LO, respectively. This differs from the first modulation unit, which receives the information signals $I_{IN}$ and $Q_{IN}$ that are used to modulate the I LO and Q LO, respectively. The modulated components from the first and second modulation units are provided to, and combined by summer 412c to generate the modulated signal.

Various modifications can be made to the specific embodiment shown in FIG. 4. For example, the I LO to mixer 410c can be inverted instead of the quadrature signal $Q_{IN}$. Moreover, the second modulation unit can be designed to receive non-inverted information and carrier signals, and to internally perform the signal inversion. For example, the second modulation unit can internally invert either the quadrature signal $Q_{IN}$ or the I LO before mixer 410c, or alternatively can invert the output of mixer 410c. In implementations of the modulator using differential signals, inversion of either the carrier signal, the information signal, or the mixer output can be readily achieved by simply swapping the differential signal lines.

The specific embodiment of modulator 400 shown in FIG. 4 can performs quadrature modulation (e.g., QPSK or OQPSK, depending on the timing alignment of the information signals $I_{IN}$ and $Q_{IN}$). The invention can be extended to other modulation schemes (e.g., BPSK, PSK, and so on). Generally, two modulation units are provided. One unit modulates the carrier signals with the information signals in accordance with a particular modulation scheme. The other unit receives the information and carrier signals, performs the proper signal swapping and inversion as necessary, and modulates the carrier signals with the information signals in accordance with the particular modulation scheme. The modulated components from the two modulation units are then combined to generate the modulated signal.

FIG. 4 also shows a block diagram of a specific embodiment of a LO generator 440 that can be used in conjunction with the modulator of the invention. LO generator 440 can be used as LO generator 240 in FIG. 2. Within LO generator 440, an IF carrier signal (IF LO) is provided to a phase shift network 450 that provides two output carrier signals that are in quadrature, i.e., one carrier signal having an additional 90 degrees of phase shift relative to the other carrier signal. The inphase and quadrature outputs from phase shifting circuit 450 are provided to mixers 452b and 452a, respectively. Each mixer 452 also receives the RF carrier signal (RF LO) and mixes the two received carrier signals. The output from mixers 452a and 452b are provided to phase shift networks 460a and 460b, respectively. Each phase shift network 460 generates an inphase component and a quadrature component of the input signal. The outputs from phase shift networks 460a and 460b are cross-coupled and provided to summers 462a and 462b. Summer 462a receives and adds the inphase component from phase shift network 460a and the quadrature component from phase shift network 460b to generate the inphase carrier signal I LO. Summer 462b receives and subtracts the quadrature component from phase shift network 460a from the inphase component from phase shift network 460b to generate the quadrature carrier signal Q LO.

If the RF LO is expressed as $\sin(\omega_{RF})$ and the IF LO is expressed as $\cos(\omega_{IF})$, the I LO and Q LO can be expressed as:

$$I\ LO = \cos(\omega_{RF} - \omega_{IF})\ , \text{ and} \qquad\qquad \text{Eq. (4)}$$

$$Q\ LO = \sin(\omega_{RF} - \omega_{IF}). \qquad\qquad \text{Eq. (5)}$$

Other LO generators can also be used with the modulator and demodulator of the invention. For example, the invention can be used in combination with the LO generator described in U.S. Patent No. 5,412,351, entitled "Quadrature Local Oscillator Network."

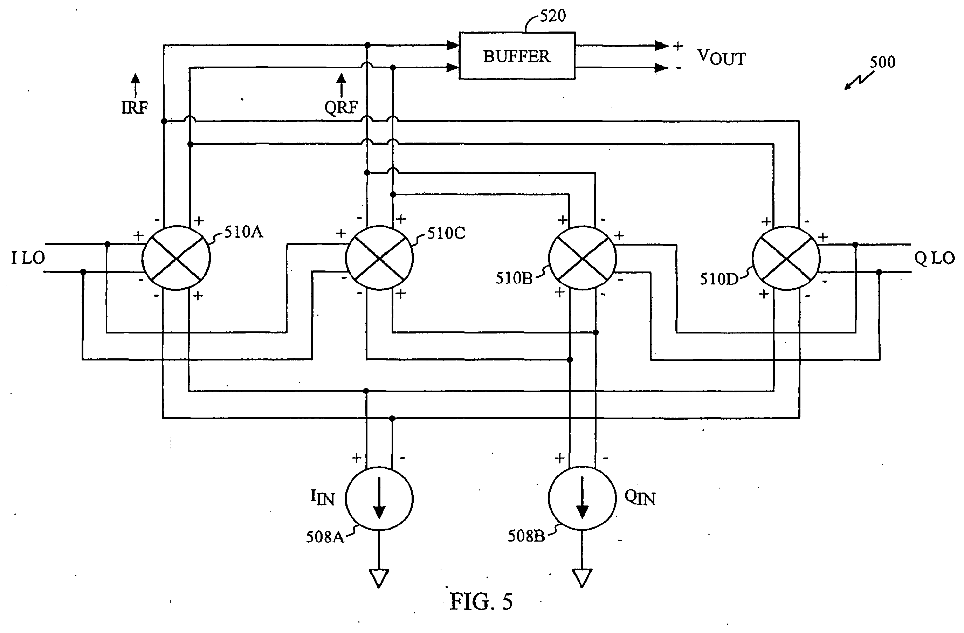

FIG. 5 shows a block diagram of an embodiment of a quadrature modulator 500 of the invention. Modulator 500 is one implementation of modulator 400 in FIG. 4. Mixers 510a through 510d in FIG. 5 correspond to mixers 410a through 410d in FIG. 4.

Within modulator 500, the inphase information signal $I_{IN}$ is represented by a current source 508a that provides a current proportional to the inphase signal $I_{IN}$. This current source can be a part of a transconductance circuit that receives an input voltage signal, and generate an output current signal. Similarly, the quadrature information signal $Q_{IN}$ is represented by a current source 508b that provides a current proportional to the quadrature signal $Q_{IN}$. As shown in FIG. 5, each current source 508 provides a differential output (current) signal.

The differential inphase carrier signal I LO is provided to the inputs of mixers 510a and 510c, and the differential quadrature carrier signal Q LO is provided to the inputs of mixers 510b and 510d. Mixers 510a and 510d also couple to current source 508a, and mixers 510b and 510c also couple to current source 508b. It should be noted that the differential signal lines between mixer 510c and current source 508b are swapped to provide a signal inversion. Specifically, the current signal related to $I_{IN}$ is provided to mixers 510a and 510d without an inversion, and the current signal related to $Q_{IN}$ is provided to mixer 510b without an inversion and to mixer 510c with an inversion.

Each mixer 510 mixes the information and carrier signals to generate a differential output current signal. For mixers 510 having current outputs, the summing functions can be implemented by coupling together the appropriate signal lines. Thus, the outputs from mixers 510a and 510d can be conveniently coupled together to form the inphase modulated component $I_{RF}$, and the outputs from mixers 510b and 510c can be conveniently coupled together to form the quadrature modulated component $Q_{RF}$. For some modulator implementations, the modulated components $I_{RF}$ and $Q_{RF}$ are provided as the modulator output signals. For some other modulator implementations, the inphase and quadrature modulated components are combined to form a modulated signal $I_{MOD}$ from the modulator. A buffer 520 receives and buffers the current signal, and can also be designed to convert the differential current signal to a differential voltage signal $V_{OUT}$.

The modulated signal from modulator 500, for mixers implemented with bipolar transistors, can be expressed as:

$$I_{MOD} = I_{RF} + Q_{RF} \; , \qquad\qquad \text{Eq. (6)}$$

$$I_{RF} = 2\Delta i \bullet M_I(t) + 2\Delta q \bullet M_Q(t) \; , \qquad\qquad \text{Eq. (7)}$$

$$Q_{RF} = 2\Delta i \bullet M_Q(t) - 2\Delta q \bullet M_I(t) \; , \qquad\qquad \text{Eq. (8)}$$

where

$I_{MOD}$ is the output current representative of the modulated signal;
$I_{RF}$ is the I modulated component;
$Q_{RF}$ is the Q modulated component;
$\Delta i$ is the differential current related to the inphase information signal $I_{IN}$

$$\{\Delta i = \alpha(I_{IN+} - I_{IN-})/2\};$$

$\Delta q$ is the differential current related to the quadrature information signal $Q_{IN}$

$$\{\Delta q = \alpha(Q_{IN+} - Q_{IN-})/2\};$$

$\alpha$ is a constant related to the transconductance gain of current sources 508;
$M_I(t)$ is the I channel mixing function; and
$M_Q(t)$ is the Q channel mixing function.

With current source 508a coupled to mixers 510a and 510d and current source 508b coupled to mixers 510b and 510c, $M_I(t)$ and $M_Q(t)$ can be expressed as:

$$M_I(t) = \frac{\sinh\left(\dfrac{I\,LO}{2V_T}\right)}{\cosh\left(\dfrac{I\,LO}{2V_T}\right) + \cosh\left(\dfrac{Q\,LO}{2V_T}\right)} \; , \text{ and} \qquad\qquad \text{Eq. (9)}$$

$$M_Q(t) = \frac{\sinh\left(\dfrac{Q\ LO}{2V_T}\right)}{\cosh\left(\dfrac{I\ LO}{2V_T}\right) + \cosh\left(\dfrac{Q\ LO}{2V_T}\right)} \qquad \text{Eq. (10)}$$

$I_{MOD}$ can then be expressed as:

$$I_{MOD} = \frac{2\Delta i\left[\sinh\left(\dfrac{I\ LO}{2V_T}\right) + \sinh\left(\dfrac{Q\ LO}{2V_T}\right)\right] + 2\Delta q\left[\sinh\left(\dfrac{Q\ LO}{2V_T}\right) - \sinh\left(\dfrac{I\ LO}{2V_T}\right)\right]}{\cosh\left(\dfrac{I\ LO}{2V_T}\right) + \cosh\left(\dfrac{Q\ LO}{2V_T}\right)} \qquad \text{Eq. (11)}$$

Equation (11) includes four "sinh" terms, with the first through fourth sinh terms generated by mixers 510a, 510d, 510b, and 510c, respectively.

Modulator 500 includes two modulation units. One modulation unit includes mixers 510a and 510b, and the other modulation unit includes mixers 510c and 510d. Current sources 508a and 508b provide currents representative of the information signals. Each current source 508 couples to one mixer in each of the two modulation units. The two modulation units provide two single sideband (SSB) outputs (i.e., two modulated components) that are in quadrature. Each of the SSB outputs has improved image rejection performance that is provided, in part, by the mixing functions $M_I$(t) and $M_Q$(t) shown in equations (9) and (10). The SSB outputs can be summed together to provide the modulated signal.

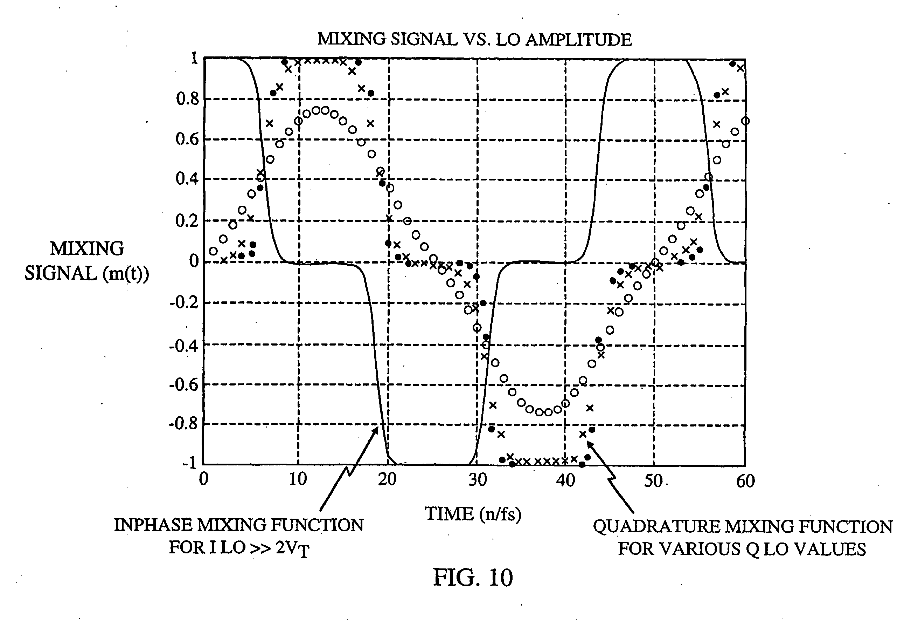

FIG. 10 shows plots of the mixing functions $M_I$(t) and $M_Q$(t). It can be noted that the mixing function has three approximately signal levels when the amplitude of the carrier signal is much greater than $2V_T$ (i.e., I LO and Q LO>> $2V_T$). As the signal level decreases, the mixing function resembles a sinusoid.

Modulator 500 operates in the following manner. Each information signal $I_{IN}$ or $Q_{IN}$ controls a respective current source. The current through each current source varies depending on the value of the respective information signal. The current through each current source is effectively steered from the mixer in one modulation unit to the mixer in the other modulation unit as the carrier signal changes phase, resulting in the mixers being alternatively turned on and off (i.e., every 90 degrees). This results in a mixing function that has three signal levels, instead of two signal levels for conventional mixers. The current steering reduces the modulator's sensitivity to the switching edges of the carrier signals.

In the implementation shown in FIG. 5, the carrier signals are provided to the inputs of the mixers. The carrier signals control the switching of the mixers and should be of sufficient amplitude to effectively switch the mixers. In fact, a reduction in sensitivity to phase error, up to a limit, may be obtained by sharpening the switching edges of the carrier signals.

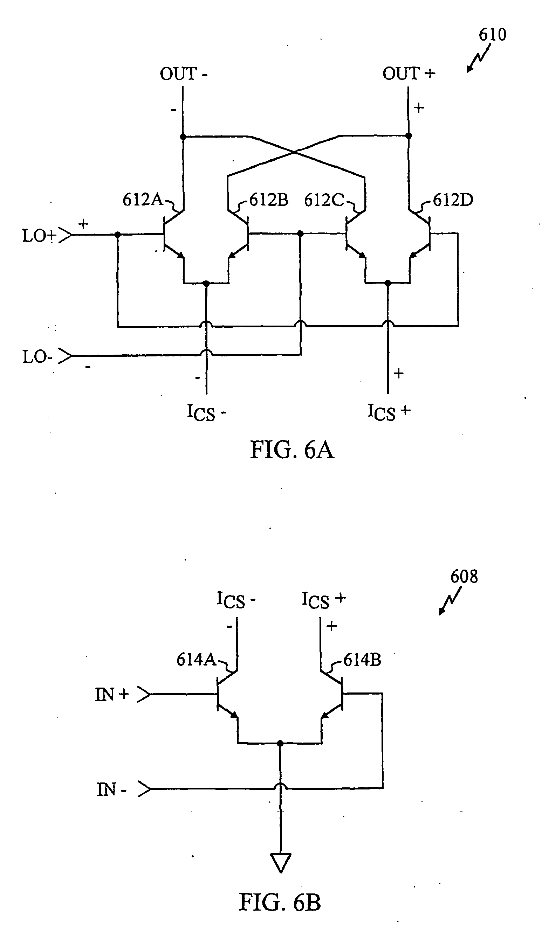

FIG. 6A shows a schematic diagram of a specific embodiment of a Gilbert cell multiplier (or mixer) 610. Mixer 610 is a specific implementation of mixer 510 in FIG. 5 and includes a pair of cross-coupled differential amplifier. The first differential amplifier comprises transistors 612a and 612b having their bases coupled to the carrier signals LO+ and LO-, respectively, and their emitters coupled together. Similarly, the second differential amplifier comprises transistors 612c and 612d having their bases coupled to the carrier signals LO- and LO+, respectively, and their emitters also coupled together. The differential carrier signal LO+ and LO- corresponds to either the inphase carrier signal I LO or the quadrature carrier signal Q LO in FIG. 5.

The emitters of transistors 612a and 612b couple to a current source that provides the current signal Ics-, and the emitters of transistors 612c and 612d couple to a current source that provides the current signal Ics+. The collectors of transistors 612a and 612c couple together and form the mixer output OUT-, and the collectors of transistors 612b and 612d couple together and form the mixer output OUT+. Each of the six inputs and outputs of mixer 610 is appropriately marked as either a (+) or (-) terminal, corresponding to the (+) and (-) designations shown in FIG. 5. Mixer 610 functions similar to a Gilbert cell multiplier known in the art.

FIG. 6B shows a schematic diagram of a specific embodiment of a transconductance amplifier 608 that receives an input voltage signal and generates an output current signal. Amplifier 608 is a specific implementation of current source 508 in FIG. 5. Amplifier 608 includes transistors 614a and 614b configured as a differential amplifier and having their emitters coupled together and to circuit ground. The bases of transistors 614a and 614b couple to the information signals IN+ and IN-, respectively. The signal IN can be the inphase or quadrature information signal $I_{IN}$ or $Q_{IN}$ in FIG. 5. The collectors of transistors 614a and 614b provide the output current signals Ics- and Ics+, respectively. The differential current signal is provided to the mixers. In FIG. 5, it should be noted that the interconnections between mixer 510c and current source 508b are swapped to generate an inverted quadrature information signal $-Q_{IN}$.

Mixer 610 and transconductance amplifier 608 represent one implementation of mixer 510 and current source 508. Other implementations can also be designed and are within the scope of the invention. Transconductance amplifier 608 typically has a transfer function that is non-linear. In some implementations, a digital-to-analog converter (DAC) can be used to provide linear current. One DAC would be provided for each of current sources 508a and 508b, and would couple directly to the associated mixers 510. The mixers can also be implemented as single balance or double balance diode mixers, as is known in the art. In general, the mixers can be implemented using non-linear devices. For improved performance, the mixing functions are typically matched to the particular mixer implementation.

The modulator architecture of the invention provides improved performance and many advantages over conventional modulator architectures. The improvements include less sensitivity to amplitude and phase errors in the carrier signals, and less sensitivity to gain and phase errors in the mixers. Some of these advantages are described below.

First, the modulator architecture of the invention is more tolerant to amplitude and phase errors than conventional modulator architectures.

Second, the modulators of the invention provide improved image rejection for single side band (SSB) modulation, through the use of a modified mixing function. In some applications, SSB modulation is preferred or required. Typically, the information signals used to modulate the carrier signals include spectral components in positive as well as negative frequencies. When carrier signals are modulated with these information signals (i.e., using modulator 300 in FIG. 3A), an image appear at the sum and difference frequencies, resulting in a double side band (DSB) modulated signal. The modulator of the invention provides two SSB modulated components (i.e., one from each modulation unit). Each of the I and Q modulated components has good image rejection.

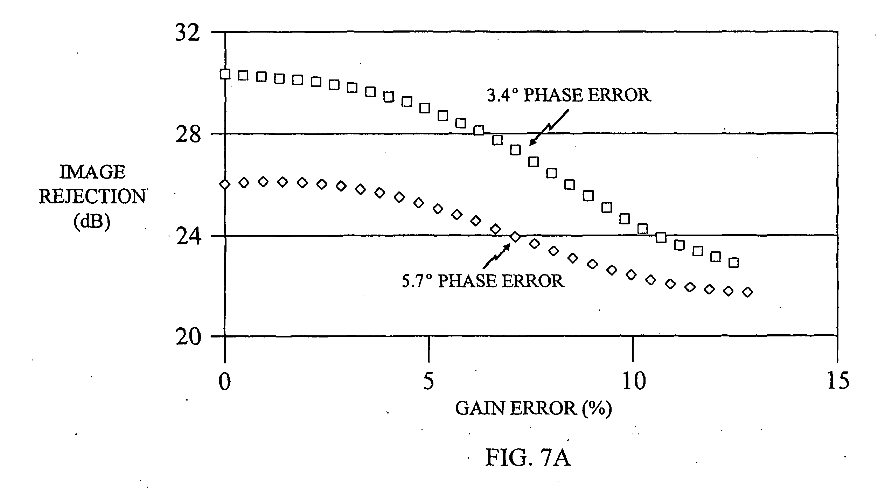

FIG. 7A shows a plot of image rejection versus gain error for a conventional modulator. This conventional modulator includes a pair of mixers, similar to modulator 300 in FIG. 3A. The conventional modulator provides approximately 26 dB of image rejection with 5.7 degrees of phase error and no gain errors. The image rejection improves to approximately 30 dB with 3.4 degrees of phase error and no gain errors. At a gain error of 6 percent, the image rejection is approximately 25 dB and 28 dB for phase errors of 5.7 degrees and 3.4 degrees, respectively.

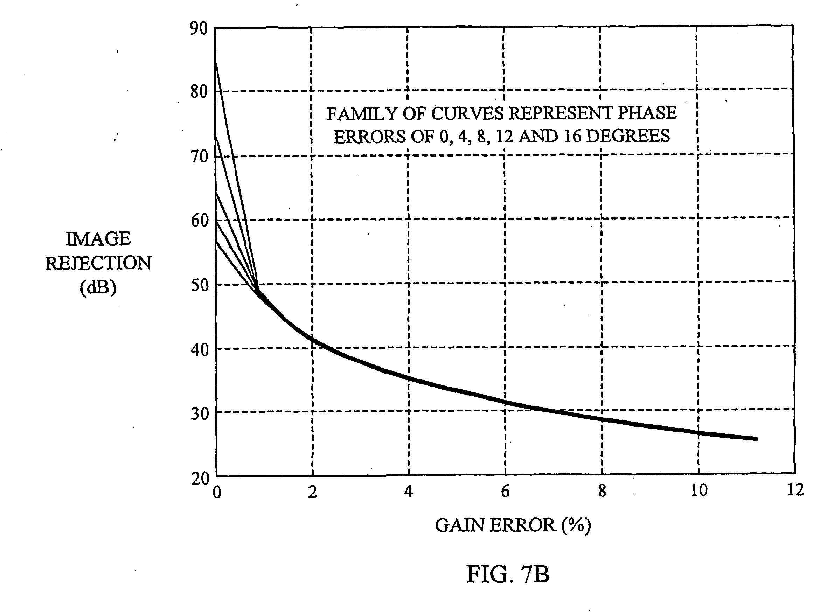

FIG. 7B shows a plot of image rejection versus gain error for modulator 400. Modulator 400 provides over 50 dB of image rejection with zero to 16 degrees of phase error and no gain errors. At a gain error of 6 percent, the image rejection is approximately 30 dB for phase errors of between zero to 16 degrees.

Third, the modulator architecture of the invention provides reduced cross-talk between the demodulated I and Q signals. For quadrature modulation, the inphase and quadrature information signals are used to generate the inphase and quadrature modulated components, respectively, that are combined to form the modulated signal. At the receiver, the modulated signal is demodulated using an inphase carrier signal and a quadrature carrier signal (generated at the receiver) to decompose the modulated signal into the inphase and quadrature signals (corresponding to the inphase and quadrature information signals, respectively). For an ideal modulated signal that is demodulated with an ideal demodulator, the demodulated inphase signal does not include any quadrature component, and the demodulated quadrature signal does not include any inphase component. However, it can be shown that any amplitude and/or phase error in the modulated signal results in I-Q crosstalk at the receiver, or a demodulated inphase signal containing some amounts of quadrature component, and vice versa. The modulator architecture of the invention effectively reduces the degradation in the modulated signal due to amplitude and phase errors, which then results in less crosstalk at the receiver.

For clarity, the invention has been described in the context of a quadrature modulator within a transmitter. The invention can also be applied to other types of modulators, such as PSK and QAM modulators, and others. The invention can also be embodied in a demodulator that receives a RF modulated signal and demodulates the signal to generate demodulated signals.

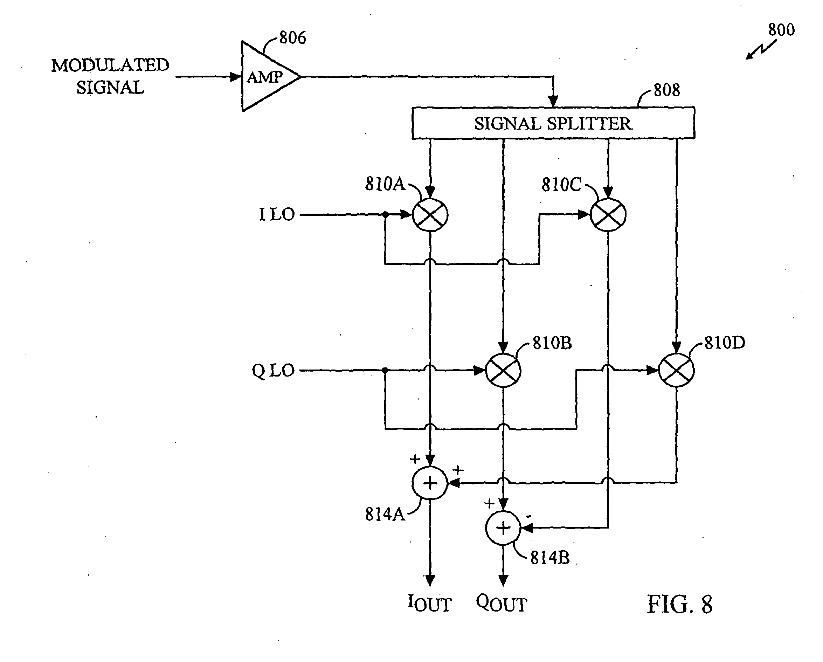

FIG. 8 shows a block diagram of an embodiment of a quadrature demodulator 800. Within demodulator 800, the modulated signal is provided to an amplifier 806 that buffers and amplifies the signal. The amplified signal is provided to a signal splitter 808 that provides four output signals having approximately equal amplitude and phase. The four signals are provided to mixers 810a through 810d. Each of mixers 810a and 810c also receives an inphase carrier signal I LO, and each of mixers 810b and 810d also receives a quadrature carrier signal Q LO. Each mixer demodulates the modulated signal with the carrier signal to provide a demodulated component. The demodulated components from mixers 810a and 810d are combined by a summer 814a to generate the inphase demodulated output $I_{OUT}$. The demodulated component from mixer 810c is subtracted from the demodulated component from mixer 810b by a summer 814b to generate the quadrature demodulated output $Q_{OUT}$. The demodulated outputs $I_{OUT}$ and $Q_{OUT}$ correspond to the inphase and quadrature signals $I_{IN}$ and $Q_{IN}$ at the transmitter.

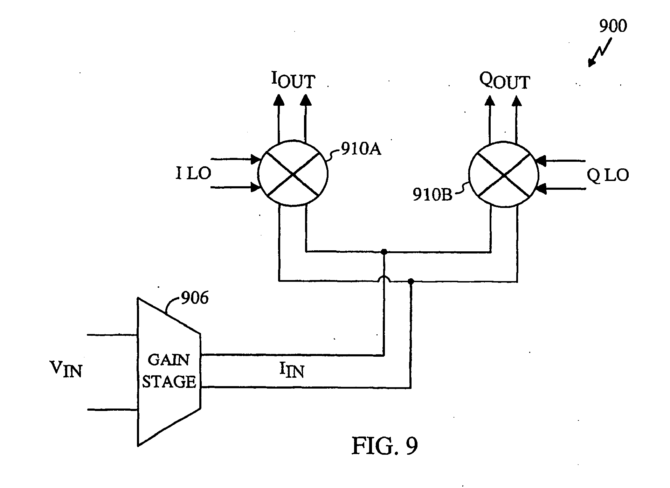

FIG. 9 shows a block diagram of another embodiment of a quadrature demodulator 900. Within demodulator 900, the modulated signal is provided to a gain stage 906 that provides a differential output current $I_{In}$. Gain stage 906 can be implemented as a transconductance amplifier, a current source, or other circuits having an output impedance much greater than the input impedance of a Gilbert cell mixer. The output of gain stage 906 couples to one input of each of mixers 910a and 910b. Mixer 910a also receives the inphase carrier signal I LO and mixer 910b also receives the quadrature carrier signal Q LO. The inphase $I_{OUT}$ and quadrature $Q_{OUT}$ demodulated components can be expressed as:

$$I_{OUT} = M_I(t) \bullet I_{in} \text{ , and} \qquad\qquad \text{Eq. (12)}$$

$$Q_{OUT} = M_Q(t) \bullet I_{in} \text{ ,} \qquad\qquad \text{Eq. (13)}$$

where $M_I(t)$ and $M_Q(t)$ are the mixing functions defined above in equations (9) and (10).

The invention has been described for a modulator and a demodulator. The invention can also be embodied in an upconverter that upconverts a signal from one frequency to another frequency. The invention can also be embodied in a downconverter that downconverts a RF signal from a higher frequency to a lower frequency. The downconverter can be implemented similar to a demodulator.

As used herein, a carrier signal refers to a signal that is modulated by an information bearing signal. The carrier signal can be implemented using various waveforms, including sine wave, square wave, triangular wave, and others. The carrier signal can include multiple frequency components (e.g., such as for the square wave), with one of the frequency components being designated as the fundamental frequency component where a major portion of the modulated signal resides.

The modulator can be implemented with a "stacked" circuit topology or a "cascaded" circuit topology. The stacked circuit topology (i.e., modulator 500 in FIG. 5) can consume less power, which is particularly advantageous, for example, in cellular telephone application. The cascaded topology may be used, for example, in applications having low supply voltages.

The modulator has been described with circuitry (e.g., Gilbert cell mixers) implemented using bipolar junction transistors (BJTs). The invention can also be implemented with other active devices including FETs, MOSFETs, MESFETs, HBTs, P-HEMTs, and others. As used herein, "transistor" generically refers to any active device, and is not limited to a BJT.

The foregoing description of the preferred embodiments is provided to enable any person skilled in the art to make or use the present invention. Various modifications to these embodiments will be readily apparent to those skilled in the art, and the generic principles defined herein may be applied to other embodiments without the use of the inventive faculty. Thus, the present invention is not intended to be limited to the embodiments shown herein but is to be accorded the widest scope consistent with the principles and novel features disclosed herein.

**Claims**

1.   A modulator (400, 500) comprising:

   a first modulation unit configured to

      receive a set of carrier signals and a set of information signals and
      modulate said set of carrier signals with said set of information signals in accordance with a particular modulation scheme to generate a first modulated component;

   a second modulation unit configured to

      receive the set of carrier signals and the set of information signals and
      modulate said set of carrier signals with said set of information signals in accordance with said particular modulation scheme to generate a second modulated component, wherein the second modulated component includes a signal inversion by inverting either a subset of the information signals or a subset of the carrier signals;

   a summer (412C) coupled to the first and second modulation units, the summer configured to receive and combine the first and second modulated components to generate a modulated signal.

2. The modulator (400, 500) of claim 1, wherein the first and second modulation units are each configured to provide a mixing function having approximately three signal levels.

3. The modulator (400, 500) of claim 1, wherein each modulation unit comprises:

   a first mixer (410A) configured to receive and modulate an inphase carrier signal with a first information signal; a second mixer (410B) configured to receive and modulate a quadrature carrier signal with a second information signal; and a summer coupled to the first and second mixers, the summer (412A) configured to receive and combine outputs from the first and second mixers to provide the modulated component, wherein the information signals provided to the first and second modulation units are swapped.

4. The modulator (400, 500) of claim 3, wherein the mixers (410AB) are implemented with Gilbert cell multipliers.

5. The modulator (400, 500) of claim 4, wherein the summer (412A) is implemented by cross-coupling outputs of the Gilbert cell multipliers.

6. The modulator (400, 500) of claim 1, wherein the signal inversion is performed by swapping differential signal lines used to provide the carrier and information signals.

7. The modulator (400, 500) of claim 1, wherein the particular modulation scheme is quadrature phase shift keying (QPSK).

8. The modulator (400, 500) of claim 1, wherein the particular modulation scheme is offset quadrature phase shift keying (OQPSK).


**Patentansprüche**

1. Ein Modulator (400, 500) der Folgendes aufweist:

   eine erste Modulationseinheit, die konfiguriert ist zum

   Empfangen eines Satzes von Trägersignalen und eines Satzes von Informationssignalen und zum Modulieren des Satzes von Trägersignalen mit dem Satz von Informationssignalen gemäß einem bestimmten Modulationsschema, um ein erste modulierte Komponente zu generieren;

   eine zweite Modulationseinheit, die konfiguriert ist zum

   Empfangen des Satzes von Trägersignalen und des Satzes von Informationssignalen und zum Modulieren des Satzes von Trägersignalen mit dem Satz von Informationssignalen gemäß dem bestimmten Modulationsschema, um eine zweite modulierte Komponente zu generieren, wobei die zweite modulierte Komponente eine Signalinversion -bzw. -umkehrung aufweist durch Invertieren bzw. Umkehren entweder eines Untersatzes von Informationssignalen oder eines Untersatzes von Trägersignalen;

   ein Summierelement (412C), das an die ersten und zweiten Modulationseinheiten gekoppelt ist, wobei das Summierelement konfiguriert ist, um die ersten und zweiten modulierten Komponenten zu empfangen und zu kombinieren, um ein moduliertes Signal zu generieren.

2. Modulator (400, 500) nach Anspruch 1, wobei die erste und zweite Modulationseinheit jeweils konfiguriert sind, um eine Mischfunktion zu liefern, die näherungsweise drei Signalpegel hat.

3. Modulator (400, 500) nach Anspruch 1, wobei jede Modulationseinheit Folgendes aufweist:

   ein erstes Mischelement (410A), das konfiguriert ist, um ein In-Phase-Trägersignal mit einem ersten Informationssignal zu empfangen und zu modulieren; ein zweites Mischelement (410B), das konfiguriert ist, um ein Quadratur-Träger-Signal mit einem zweiten In-Informationssignal zu empfangen und zu modulieren; und ein Summierelement, das an die ersten und zweiten Mischelemente gekoppelt ist, wobei das Summierelement (412A) konfiguriert ist, um die Ausgangsgrößen vom ersten und zweiten Mischelement zu empfangen und zu kombinieren, um die modulierte Komponente vorzusehen,

wobei die Informationssignale, die an die ersten und zweiten Modulationseinheiten geliefert werden, ausgetauscht werden.

**4.** Modulator (400, 500) nach Anspruch 3, wobei die Mischelemente (410AB) mit Gilbert-Zellen-Multiplikationselementen implementiert sind.

**5.** Modulator (400, 500) nach Anspruch 4, wobei das Summierelement (412A) durch Kreuzkopplung der Ausgangsgrößen der Gilbert-Zellen-Multiplikationselemente implementiert ist.

**6.** Modulator (400, 500) nach Anspruch 1, wobei die Signalinversion ausgeführt wird durch Austauschen der Differenzialsignalleitungen, die verwendet werden um die Träger- und Informationssignale zu liefern.

**7.** Modulator (400, 500) nach Anspruch 1, wobei das bestimmte Modulationsschema Quadraturphasenumtastung (QPSK) ist.

**8.** Modulator (400, 500) nach Anspruch 1, wobei das bestimmte Modulationsschema Offset-Quadraturphasenumtastung (OQPSK) ist.


**Revendications**

**1.** Modulateur (400, 500) comprenant :

une première unité de modulation agencée pour

recevoir un ensemble de signaux de porteuses et un ensemble de signaux d'informations et moduler l'ensemble de signaux de porteuses avec l'ensemble de signaux d'informations conformément à un processus de modulation particulier pour générer une première composante modulée ;

une deuxième unité de modulation agencée pour

recevoir l'ensemble de signaux de porteuses et l'ensemble de signaux d'informations, et moduler l'ensemble de signaux de porteuses avec l'ensemble de signaux d'informations conformément au processus de modulation particulier pour générer une deuxième composante modulée, la deuxième composante modulée comprenant une inversion de signal par inversion soit d'un sous-ensemble des signaux d'informations soit d'un sous-ensemble des signaux de porteuses ;

un sommateur (412C) couplé aux première et deuxième unités de modulation, le sommateur étant agencé pour recevoir et combiner les première et deuxième composantes modulées pour générer un signal modulé.

**2.** Modulateur (400, 500) selon la revendication 1, dans lequel chacune des première et deuxième unités de modulation est agencée pour assurer une fonction de mélange ayant approximativement trois niveaux de signal.

**3.** Modulateur (400, 500) selon la revendication 1, dans lequel chaque unité de modulation comprend :

un premier mélangeur (410A) agencé pour recevoir et moduler un signal de porteuse en phase avec un premier signal d'informations ;
un deuxième mélangeur (410B) agencé pour recevoir et moduler un signal de porteuse en quadrature avec un deuxième signal d'informations ; et
un sommateur couplé aux premier et deuxième mélangeurs, le sommateur (412A) étant agencé pour recevoir et combiner les sorties des premier et deuxième mélangeurs pour fournir la composante modulée,
dans lequel les signaux d'informations fournis aux première et deuxième unités de modulation sont échangés.

**4.** Modulateur (400, 500) selon la revendication 3, dans lequel les mélangeurs (410AB) sont mis en oeuvre par des multiplieurs à cellule de Gilbert.

**5.** Modulateur (400, 500) selon la revendication 4, dans lequel le sommateur (412A) est mis en oeuvre par un couplage croisé des sorties des multiplieurs à cellule de Gilbert.

**6.** Modulateur (400, 500) selon la revendication 1, dans lequel l'inversion de signal est réalisée en échangeant des lignes de signaux différentielles utilisées pour fournir les signaux de porteuses et d'informations.

**7.** Modulateur (400, 500) selon la revendication 1, dans lequel le processus de modulation particulier est une modulation par déplacement de phase en quadrature (QPSK).

**8.** Modulateur (400, 500) selon la revendication 1, dans lequel le processus de modulation particulier est une modulation par déplacement de phase en quadrature décalé (OQPSK).

FIG. 1

EP 1 876 703 B1

FIG. 2

300

MODULATED SIGNAL

312

310A

I LO

310B

Q LO

$I_{IN}$

$Q_{IN}$

FIG. 3A

320

IOUT

330B

Q LO+

334B

QIN

Q LO-

Q LO+

FIG. 3B

I LO+

334A

IIN

I LO-

330A

I LO+

FIG. 4

EP 1 876 703 B1

FIG. 5

EP 1 876 703 B1

EP 1 876 703 B1

OUT -                          OUT +

610

612A      612B    612C      612D

LO+

LO-

Ics -          Ics +

FIG. 6A

608

Ics -      Ics +

614A        614B

IN +

IN -

FIG. 6B

20

FIG. 7A

EP 1 876 703 B1

FIG. 7B

FIG. 8

EP 1 876 703 B1

FIG. 9

EP 1 876 703 B1

MIXING SIGNAL VS. LO AMPLITUDE

INPHASE MIXING FUNCTION
FOR I LO >> $2V_T$

QUADRATURE MIXING FUNCTION
FOR VARIOUS Q LO VALUES

FIG. 10

EP 1 876 703 B1

**EP 1 876 703 B1**

**REFERENCES CITED IN THE DESCRIPTION**

**Patent documents cited in the description**

- US 5438301 A
- US 5705958 A
- US 5111155 A
- US 5412351 A